# EUROPÄISCHE PATENTSCHRIFT

(11) **EP 3 103 138 B1**
(45) Veröffentlichungstag und Bekanntmachung des Hinweises auf die Patenterteilung: **03.07.2024**
(21) Anmeldenummer: 15714453.6
(22) Anmeldetag: 30.03.2015
(51) Int. Cl.: H01L 21/60, H01L 21/50, H01L 23/498, H01L 23/10, H01L 23/488, H01L 23/473

(54) **VERFAHREN ZUM MONTIEREN EINES ELEKTRISCHEN BAUELEMENTS, BEI DER EINE HAUBE ZUM EINSATZ KOMMT**
METHOD FOR MOUNTING AN ELECTRICAL COMPONENT IN WHICH A CAP IS USED
PROCÉDÉ DE MONTAGE D'UN COMPOSANT ÉLECTRIQUE EN UTILISANT UN CAPOT

(30) Priorität: 04.04.2014 DE 102014206601
(43) Veröffentlichungstag der Anmeldung: 14.12.2016
(73) Patentinhaber: Siemens Aktiengesellschaft, 80333 München (DE)
(72) Erfinder: BUSCHE, Nora, 10555 Berlin (DE); STROGIES, Jörg, 14163 Berlin (DE); WILKE, Klaus, 12527 Berlin (DE)
(74) Vertreter: Siemens Patent Attorneys
(86) Internationale Anmeldenummer: PCT/EP2015/056912
(87) Internationale Veröffentlichungsnummer: WO 2015/150335

(56) Entgegenhaltungen:
- EP-A2- 2 685 495
- DE-B3-102007 057 346
- JP-A- 2006 352 080
- US-A1- 2008 111 230
- US-B1- 6 340 842

## Beschreibung

Verfahren zum Montieren eines elektrischen Bauelements, bei dem eine Haube zum Einsatz kommt.

Die Erfindung ist im beigefügten Anspruchssatz beschrieben. Sie betrifft ein Verfahren zum Montieren eines elektrischen Bauelements auf einem Substrat, wobei das Bauelement eine dem Substrat zugewandte Unterseite und eine dieser gegenüberliegende Oberseite aufweist. Bei dem Verfahren wird die Unterseite des Bauelements mit der durch das Substrat zur Verfügung stehenden Baugruppe mechanisch verbunden.

Die Oberseite des Bauelements wird dann mit einer Kontaktierungsstruktur mechanisch verbunden. Dabei liegen die Fügeverbindungen, die beim Fügen entstehen, in mindestens zwei unterschiedlichen Fügeleveln.

Die Fügelevel werden dadurch definiert, dass sich die Kontakte elektronischer Bauelemente beim Montieren auf einem Substrat und beim Kontaktieren in verschiedenen Ebenen befinden, wobei der Ausdruck Ebene hier im technischen und nicht im mathematischen Sinne gemeint ist. Eine Ebene oder auch der zugehörige Fügelevel definiert Bereiche, in denen bestimmte Fügeverbindungen der zu kontaktierenden Bauelemente liegen.

Durch die Anordnung von Bauelementen übereinander liegen die Fügelevel vorzugsweise ebenfalls übereinander, insbesondere in paralleler Ausrichtung zueinander.

Verfahren zum Montieren von elektronischen Bauelementen auf Substraten sind bekannt. Diese Montageverfahren finden auch bei der Montage von elektronischen Baugruppen der Leistungselektronik Anwendung. Beispielsweise ist in der DE 100 62 108 A1 beschrieben, dass ein Leistungsmodul ausgebildet werden kann, bei dem die elektronischen Leistungsbauelemente über eine Sinterschicht mit dem Substrat verbunden werden können. Bei dem Substrat kann es sich um in der Leistungselektronik üblicherweise verwendete DCB-Keramiksubstrate handeln (DCB steht für Direct Copper Bond). Die Oberseiten der Leistungsbauelemente können mit einer Sinterschicht beispielsweise an eine zusätzliche Wärmekapazität angeschlossen werden, die einen Kühlkörper zur Verfügung stellt. Genauso kann das Substrat mit seiner Unterseite über eine Sinterschicht mit einem weiteren Kühlkörper verbunden werden.

Gemäß der DE 10 2007 047 698 A1 ist bekannt, dass die Sinterverbindungen elektronischer Baugruppen mit Hilfe spezieller Werkzeuge gefertigt werden können. Diese Werkzeuge weisen Druckflächen auf, die die zu sinternden Bauteile berühren, so dass während der Sinterbehandlung ein Druck auf diese ausgeübt werden kann. Über Toleranzausgleiche in dem Werkzeug kann gewährleistet werden, dass der aufgebrachte Druck auch dann gleichmäßig ist, wenn die zu sinternde Baugruppe toleranzbedingte Fertigungsungenauigkeiten aufweist. Bei der Sinterbehandlung wird zusätzlich zu dem Druckaufbau das Erreichen einer bestimmten Sintertemperatur über einen definierten Zeitraum erforderlich. Statt Sinterverbindungen können auch Lötverbindungen vorgesehen werden.

Gemäß der US 2013/0201631 A1 ist darauf zu achten, dass die für den Sintervorgang notwendigen Temperaturen so gewählt sind, dass bereits montierte Fügeverbindungen in der Baugruppe durch die gerade stattfindende Wärmebehandlung nicht wieder aufgeschmolzen werden. Dies wird dadurch erreicht, dass die Bauteilverbindungen, die vor dem betreffenden Verbindungsvorgang schon durchgeführt wurden, Verbindungsmaterialen aufweisen, deren Prozesstemperaturen (Erweichungstemperatur, Sintertemperatur, Schmelztemperatur) mit einem genügenden Sicherheitsabstand oberhalb derjenigen Prozesstemperatur des gerade stattfindenden Verbindungsprozesses liegen. Auf diesem Wege werden die bereits ausgebildeten Fügeverbindungen hinsichtlich ihrer Integrität durch den gerade ablaufenden Verbindungsvorgang nicht gefährdet.

Nach erfolgter Montage der Bauelemente auf dem Substrat muss in der Regel noch eine Kontaktierung dieser Bauelemente mit dem Substrat über geeignete Kontaktierungsstrukturen erfolgen. Dabei werden an der Oberseite des Bauelements liegende Kontakte mit korrespondierenden Kontakten auf dem Substrat verbunden. Hierzu können neben den allgemein bekannten Bonddrähten gemäß der US 2012/0106109 A1 auch metallische Leitstrukturen verwendete werden, die beispielsweise Teil eines Leadframes sein können. Die in geeigneter Weise gebogenen Leitstrukturen werden vorzugsweise mittels Sintern oder Löten mit den betreffenden Kontaktflächen verbunden. Eine andere Möglichkeit besteht darin, die Kontaktierungsstrukturen durch Flexfolien zur Verfügung zu stellen, auf denen die Leitstruktur beispielsweise aufgedruckt ist. Auch die Flexfolien können gemäß der DE 10 2009 016 112 A1 mittels Sinterverbindungen an den betreffenden Kontaktflächen der Oberseite des Bauelements und der Montageseite des Substrats verbunden werden.

Durch die bei Aufbauten der Leistungselektronik umgesetzten elektrischen Leistungen werden die leistungselektronischen Baugruppen thermisch und elektrisch stark belastet, weswegen die elektrischen Verbindungen und anderen Fügeverbindungen eine hohe Zuverlässigkeit aufweisen müssen. Gerade Sinterverbindungen eignen sich zu diesem Zweck in besonderem Maße, da ihre thermische Stabilität sowie eine fehlerfreie Ausbildung der Fügeverbindung gewährleistet werden können. Allerdings bedeutet die Montage leistungselektronischer Baugruppen durch Sinterverbindungen im Vergleich beispielsweise zum Löten zur Zeit einen gewissen Mehraufwand in der Fertigung.

Gemäß der US 6,340,842 B1 können elektronische Bauelemente auch auf einem Schaltungsträger montiert werden, der zu diesem Zweck mit einer Kavität versehen wurde. Die Kavität bildet eine Mulde, welche nach Montage der elektronischen Bauelemente mit einem Harz versiegelt werden kann. In die Mulde führen zur Kontaktierung der elektronischen Bauelemente Leiterbahnen, die außen auf dem Rand des Schaltungsträgers geführt werden. Dort entstehen dadurch Kontaktflächen, die mit Lotwerkstoff versehen werden können. Der Schaltungsträger kann dann mit einem weiteren Schaltungsträger zusammengefügt werden, wobei die Kavität dem weiteren Schaltungsträger zugewandt ist. Eine elektrische Verbindung zwischen den beiden Schaltungsträgern wird über Lötverbindungen hergestellt.

Gemäß der EP 2685495 A2 wird ein elektronisches Bauteil auf einem ersten Schaltungsträger montiert. Ein weiterer Schaltungsträger wird danach mit dem Bauteil und mit dem ersten Schaltungsträger in demselben Arbeitsgang durch Lötkugeln verbunden, wobei der zweite Schaltungsträger das Bauteil überspannt.

Gemäß der US 2008/0111230 A1 wird ein elektronisches Bauteil auf einem ersten Träger positioniert. Diese Baugruppe wird dann mit einem zweiten folienartigen Schaltungsträger laminiert, wobei das Bauteil zwischen den Trägern einlaminiert und versiegelt ist.

Gemäß der DE 102007057346 B3 werden auf einem Drucksintermaterial, das auf einem Substrat angeordnet ist, Halbleiterbauelemente positioniert. Ein zweiter folienartiger Schaltungsträger wird dann auf diese Baugruppe positioniert, sodass der Schaltungsträger die Halbleiterbauelemente überspannt und weiteres Drucksintermaterial, welches sich auf der Oberseite der Halbleiterelemente und des Substrates befindet, kontaktiert. Durch Druck werden dann in demselben Arbeitsgang mechanische und elektrische Verbindungen zwischen den Halbleiterelementen und dem Substrat, sowie zwischen den Halbleiterelementen und dem Schaltungsträger und zwischen dem Schaltungsträger und dem Substrat hergestellt.

Die Aufgabe der Erfindung besteht darin, ein Verfahren zum Montieren eines elektrischen Bauelements und einer Haube auf einem Substrat anzugeben, wobei dieses vereinfacht wird und auch die Montage von leistungselektronischen Bauelementen zulässt.

Diese Aufgabe wird mit dem eingangs angegebenen Verfahren erfindungsgemäß dadurch gelöst, dass die Kontaktierungsstruktur in Form von Leitpfaden auf der Innenseite einer Haube wie in Anspruch 1 definiert ausgeführt ist.

Die Haube ist erfindungsgemäß als LTCC-Bauteil oder als MID-Bauteil ausgeführt. Bei LTCC-Bauteilen handelt es sich um Bauteile, die in der sogenannten LTCC-Technologie hergestellt wurden. Diese Abkürzung steht für das Verfahren der "Low Temperature Co-fired Ceramics" also Keramiken, die bei geringen Temperaturen hergestellt werden und bei denen elektrische Schaltungen oder auch Leiterbahnen, die die Kontaktstruktur bilden können, eingebrannt werden. Die Herstellung solcher Bauteile ist an sich bekannt, beispielsweise durch Boleslav Psota et al., "Usage of LTCC Technology in Electronic Packaging" 36th Int. Spring Seminar on Electronics Technology, IEEE 2013, ab Seite 206. Wird die Haube als MID-Bauteil dargestellt, bedeutett dies, dass die sogenannte MID-Technologie verwendet wird. Diese Abkürzung steht für ein Verfahren, bei dem sogenannte "Molded Interconnect Devices" hergestellt werden. Die Kontaktierungsstrukturen werden dabei beispielsweise in ein Bauteil eingegossen. Diese TEchnologie ist ebenfalls allgemein bekannt, zum Beispiel aus N.Bachnak, "3D-MID Technology MEMS Connectivity at System Level" IEEE 2012, ab Seite 572.

Bei der Montage wird diese Haube auf eine Montageseite des Substrates aufgesetzt, wobei eine elektrische Kontaktierung der Kontaktierungsstruktur mit dem Substrat innerhalb eines ersten Fügelevels, der durch die Montageseite des Substrats zur Verfügung gestellt wird, erzeugt wird. Die Haube überspannt das Bauelement und auf der Innenseite der Haube wird innerhalb eines zweiten Fügelevels auf Höhe der Oberseite des Bauelementes eine elektrische Kontaktierung der Kontaktierungsstruktur mit dem Bauelement erzeugt. Dies bedeutet, dass Kontaktflächen der Kontaktierungsstruktur jeweils auf einem ersten Fügelevel auf dem Niveau der Montageseite des Substrates und auf einem zweiten Fügelevel auf dem Niveau der Oberseite des Bauelementes vorgesehen sind. Die Kontaktierungsstruktur überbrückt damit zwei unterschiedliche Fügelevel, die vorteilhaft ohne beispielsweise die Zuhilfenahme von Bonddrähten oder freistehenden Leadframes durch Aufsetzen der Haube in einem Montageschritt zuverlässig gefügt werden können. Dabei können auch Fertigungstoleranzen bei der Kontaktierung von Kontaktflächen in unterschiedlichen Fügeleveln verringert werden, da diese in einem vergleichsweise einfach und genau zu fertigenden Bauteil, nämlich der Haube, schon bei der Herstellung derselben integriert werden können. Eine nachträgliche Montage von einzeln stehenden Kontaktierungsstrukturen ist daher nicht erforderlich. Eine Positionierung der Kontaktierungsstrukturen erfolgt vorteilhaft gemeinsam mit der Positionierung der Haube auf dem Substrat.

Erfindungsgemäß ist vorgesehen, dass das Substrat, das Bauelement und die Haube mit der Kontaktierungsstruktur zuerst in der zu erzeugenden Konfiguration zueinander platziert werden. Erst danach sollen die Fügeverbindungen, insbesondere elektrische Verbindungen, am Bauelement innerhalb der mindestens zwei Fügelevel in ein und demselben Arbeitsgang durch eine Temperaturerhöhung oder eine Temperatur- und Druckerhöhung fertiggestellt werden. Gemäß der Erfindung ist mit anderen Worten vorgesehen, dass das Verfahren zur Montage der elektronischen Baugruppe auf dem Substrat in zwei definierten Prozessabschnitten ablaufen soll. Im ersten Prozessabschnitt werden alle zu montierenden Bauteile der durch das Substrat zur Verfügung gestellten Baugruppe zueinander platziert. Hierbei kommt es auch zur Ausbildung der Fügeverbindungen, die allerdings noch nicht fertiggestellt sind. In der zweiten Fertigungsphase werden die Fügeverbindungen fertiggestellt. Hierzu ist die Anwendung eines geeigneten Fügeverfahrens notwendig, wobei je nach Art der herzustellenden mechanischen Verbindungen eine Temperaturerhöhung (beispielsweise beim Löten) oder eine Temperatur- und Druckerhöhung (beispielsweise beim Diffusionslöten oder beim Sintern) erforderlich ist. Vorteilhaft ist vorgesehen, dass diese Fügeverbindungen in einem Arbeitsgang hergestellt werden können. Hierzu ist es erforderlich, alle zu erzeugenden Fügeverbindungen auf die bei diesem einzigen Arbeitsgang eingestellten Prozessparameter auszulegen. Hierbei wird ein bestimmtes Temperaturniveau erreicht. Außerdem kann zumindest auf einen Teil der Verbindungen zusätzlich ein Druck ausgeübt werden. Die jeweils gewählte Verbindungsart sowie evtl. notwendiges Zusatzmaterial muss nicht notwendigerweise bei allen Fügeverbindungen genau gleich sein. Wesentlich ist lediglich, dass die Prozessparameter bei allen Verbindungsarten und Materialien aufeinander abgestimmt sind und auf diese Weise die gleichzeitige Ausbildung aller Fügeverbindungen in einem Arbeitsgang möglich ist.

Durch die erfindungsgemäße gleichzeitige Ausbildung aller Fügeverbindungen wird es vorteilhaft insbesondere auch möglich, Kontaktierungsstrukturen in Form von LTCC-Bauteilen oder MID-Bauteilen zu montieren, deren insbesondere elektrischen Verbindungen auf unterschiedlichen Fügeleveln liegen. Hierbei können diese Fügelevel überbrückt werden, ohne dass ein zusätzlicher Arbeitsgang zur Ausbildung der Fügeverbindungen notwendig würde. Erfindungsgemäß liegt die Unterseite des Bauelements innerhalb eines ersten Fügelevels, der durch eine Montageseite des Substrates zur Verfügung gestellt wird und die Oberseite des Bauelements liegt innerhalb eines zweiten Fügelevels. Der erste Fügelevel wird durch die Ebene definiert, die gewöhnlich durch das Substrat zur Verfügung gestellt wird. Auf dieser Ebene (die bei nicht ebenen Substraten, wie beispielsweise Gehäusen, nicht zwangsläufig im mathematischen Sinne eben sein muss) liegt die Gruppe von Fügeverbindungen, mit denen jeweils die Unterseite der elektrischen Bauelemente auf dem Substrat kontaktiert wird. Die Oberseite der Bauelemente definiert dann, sofern diese elektrische Kontaktflächen aufweisen, einen zweiten Fügelevel, der durch die räumliche Höhenausdehnung der elektrischen Bauelemente von dem ersten Fügelevel beabstandet ist. Durch unterschiedliche Höhen der elektrischen Bauelemente kann es sein, dass der zweite Fügelevel nicht in einer Ebene liegt, wobei die Summe aller Kontaktflächen auf der jeweiligen Oberseite von Bauelementen diesen Fügelevel definiert.

In einem Beispiel, das nicht eine Ausführungsform der Erfindung ist, werden mehrere elektrische Bauelemente aufeinander gestapelt, sodass dementsprechend in jeder "Etage" des Stapels weitere Fügelevel entstehen, die beim elektrischen Anschluss durch entsprechende Kontaktstrukturen evtl. überbrückt werden müssen. Die Anordnung der elektrischen Bauelemente derart, dass ihre Kontakte jeweils unterschiedlichen Fügeleveln zugeordnet werden können, erleichtert vorteilhaft die Montage der elektrischen Baugruppe, bei der die Bauelemente und Kontaktstrukturen Level für Level vormontiert werden können (d. h. zueinander platziert werden können), um anschließend die vorzugsweise elektrischen Verbindungen in allen Fügeleveln in einem Arbeitsgang herzustellen.

Gemäß einer Ausgestaltung der Erfindung ist vorgesehen, dass das Substrat mit seiner der Montageseite abgekehrten Rückseite eine Kontaktfläche zur Verfügung stellt, mit der ein dritter Fügelevel zur Verfügung gestellt wird. Innerhalb dieses Fügelevels wird ein Bauteil platziert. Anschließend wird in der erfindungsgemäßen Weise eine Verbindung zwischen dem Bauteil und dem Substrat in genau dem Arbeitsgang durch eine Temperaturerhöhung oder eine Temperatur- und Druckerhöhung fertiggestellt, in dem auch die Fügeverbindungen am elektrischen Bauelement in dem ersten Fügelevel und dem zweiten Fügelevel (und evtl. weiteren Fügeleveln) fertiggestellt werden. Hierdurch ist vorteilhaft eine weitere Vereinfachung des Montageverfahrens möglich. Je mehr unterschiedliche Fügelevel in einem Arbeitsgang bei der Fertigstellung der Verbindungen berücksichtigt werden können, desto größer ist die Vereinfachung des Montageprozesses, was sich letztendlich auch vorteilhaft auf dessen Wirtschaftlichkeit auswirkt.

Bei dem Bauteil, welches auf der Rückseite des Substrats montiert wird, kann es sich beispielsweise um einen Kühlkörper handeln, der bei leistungselektronischen Baugruppen zu einer Abführung der Verlustwärme dient. Dieser Kühlkörper kann auch als Grundkörper ausgebildet sein, wobei dieser zur gemeinsamen Montage von mehreren elektronischen Baugruppen zur Verfügung steht. Eine andere Möglichkeit besteht darin, das Substrat beidseitig mit elektrischen Bauelementen zu bestücken. Eine Kühlung könnte in diesem Fall beispielsweise durch Kühlkanäle im Substrat erfolgen.

Gemäß einer besonderen Ausgestaltung der Erfindung ist vorgesehen, dass alle Fügeverbindungen mit ein und demselben Fügeverfahren fertiggestellt werden. Wie bereits erwähnt, ist es ebenso möglich, unterschiedliche Fügeverfahren für die einzelnen Fügeverbindungen auszuwählen. Jedoch muss die Bedingung erfüllt sein, dass die verschiedenen ausgewählten Fügeverfahren unter den vorgegebenen Prozessbedingungen (Druck, Temperatur) durchgeführt werden können. Insbesondere die Temperatur muss über die gesamte zu montierende elektrische Baugruppe gleich sein. Der Druck kann variieren, indem beispielsweise mehrere Fügewerkzeuge zum Einsatz kommen oder ein Fügewerkzeug vorgesehen wird, bei dem beispielsweise durch Federmechanismen mit unterschiedlicher Federsteifigkeit unterschiedliche Fertigungsdrücke an unterschiedlichen Komponenten des zu fügenden Aufbaus angelegt werden. Auch für den Fall, dass alle elektrischen Verbindungen mit ein und demselben Fügeverfahren fertiggestellt werden, gelten diese Bedingungen. Besonders vorteilhaft kann bei dem ausgewählten Fügeverfahren (insbesondere Diffusionslöten oder Sintern) auch derselbe Zusatzwerkstoff ausgewählt werden, so dass die Fertigungsbedingungen für das Fügeverfahren für die gesamte Baugruppe einheitlich sind. Es ist aber auch möglich, unterschiedliche Zusatzwerkstoffe auszuwählen, soweit diese in der oben erläuterten Weise unter den vorgegebenen Fügebedingungen fertiggestellt werden können.

Gemäß einer anderen Ausgestaltung der Erfindung ist vorgesehen, dass neben den Fügeverbindungen auch die Verbindung zwischen dem Bauteil (beispielsweise dem Kühlkörper) und dem Substrat (auf der Rückseite) mit dem ausgewählten Fügeverfahren fertiggestellt werden. Hiermit können die erläuterten Vorteile auch auf das Fügen der Verbindung zwischen dem Bauteil und dem Substrat ausgeweitet werden, die sich in einem Arbeitsgang zusammen mit den Fügeverbindungen auf der Montageseite des Substrats fertigstellen lassen. Natürlich können auch die Verbindungen auf der Rückseite des Substrats elektrische Verbindungen sein, wenn das Bauteil, welches dort montiert wird, ein elektrisches Bauteil ist.

Eine wieder andere Ausgestaltung der Erfindung sieht vor, dass als Fügeverfahren ein Diffusionslöten oder ein Sintern zum Einsatz kommt. Diese Verfahren eignen sich vorteilhaft in besonderer Weise, wenn Leistungselektronik montiert werden soll, da die ausgebildeten Verbindungen eine geringe Fehlerdichte aufweisen und eine hohe thermische Stabilität besitzen. Das Diffusionslöten hat einen mit dem Sintern verwandten Verfahrensablauf. Ein Zusatzwerkstoff wird in den Bereich zwischen den zu fügenden Bauteilen eingebracht, wobei dieser unter der Einwirkung von Temperatur und ggf. erhöhtem Druck zu einer Diffusion von niedrigschmelzenden und hochschmelzenden Legierungskomponenten beiträgt. Durch diese lokalen Konzentrationsänderungen kommt es in der Fügezone und an deren Grenzflächen zu den benachbarten Bauteilen zur Generierung von hochschmelzenden intermetallischen Phasen, die eine hohe Temperaturstabilität besitzen. Die entstehende Verbindung hat sehr hohe elektrische und thermische Leitfähigkeiten sowie hohe mechanische Festigkeiten.

Weiterhin kann vorteilhaft vorgesehen werden, dass vor dem Platzieren in der zu erzeugenden Konfiguration auf das Substrat und/oder das Bauelement und/oder die Kontaktierungsstruktur in der Haube und/oder das Bauteil ein Zusatzwerkstoff aufgebracht wird. Wie bereits erwähnt, können diese Zusatzwerkstoffe das Fügen, beispielsweise das Sintern oder das Diffusionslöten erleichtern. Die für die Sintervorgänge bzw. Diffusionsvorgänge verantwortlichen Verbindungsbestandteile können allerdings auch in die Kontaktflächen für die auszubildende Verbindung enthalten sein. Beim klassischen Löten ist allerdings als Zusatzwerkstoff immer ein Lotwerkstoff erforderlich.

Eine andere Ausgestaltung der Erfindung sieht vor, dass die Haube außen eine ebene Fläche aufweist, die parallel zum Substrat verläuft. Dies hat große Vorteile für den Ablauf des Montageverfahrens, welcher dadurch vereinfacht wird. Eine ebene Fläche erlaubt nämlich das einfache Aufsetzen eines Fügewerkzeugs, mit dem der Druck auf die zu montierende Baugruppe ausgeübt werden kann. Über dieses Werkzeug lässt sich im Übrigen auch die erforderliche Prozesswärme einbringen, wenn dieses erwärmt wird. Die Übertragung der Prozesswärme auf die zu fügenden Bauteile, insbesondere die Haube, wird ebenfalls verbessert, wenn eine ebene Fläche zur Verfügung steht, die sich insbesondere über die gesamte Flächenausdehnung der Haube erstreckt. Ein weiterer Vorteil besteht darin, dass das Fügewerkzeug geometrisch nicht an die Haube angepasst werden muss. Das Fügewerkzeug kann standardmäßig mit einer ebenen Fläche zur Druckausübung ausgestattet sein, wobei grundsätzlich Hauben unterschiedlicher Anwendungsfälle, also beispielsweise mit unterschiedlicher Größe oder mit unterschiedlicher Strukturierung der Innenseite, mit ein und demselben Fügewerkzeug montiert werden können.

Eine andere Ausgestaltung der Erfindung erhält man, wenn auf der Innenseite mindestens eine Fügefläche vorgesehen ist, die bei der Montage auf dem Substrat mit dem Bauelement in Eingriff gelangt. Hierdurch ist es vorteilhaft möglich, auch das Bauelement durch Aufsetzen der Haube zumindest in einer Raumrichtung eindeutig gegenüber dem Substrat auszurichten und zu fixieren. Beispielsweise kann die Fügefläche als waagerechte Fläche auf der Innenseite der Haube vorgesehen sein. Eine solche Fügefläche ermöglicht die Positionierung des Bauelements in Richtung senkrecht zur Oberfläche des Substrats. Durch die Fügefläche kann insbesondere auch ein erforderlicher Druck aufgebaut werden, der für das Fügen der elektrischen Kontakte beispielsweise mittels einer Sinterbehandlung oder einer Ausbildung von Diffusionslötverbindungen erforderlich ist. Die Ausbildung des Fügedrucks kommt hierbei durch ein Übermaß der Fügefläche im Vergleich zum Aufsetzniveau der Haube auf dem Substrat zustande, welche zu einer elastischen Verformung der Haube führt. Mit anderen Worten ist die lichte Höhe in der durch die Haube auf dem Substrat ausgebildeten Kavität unterhalb des Bauelements geringer als die Bauhöhe des Bauelements im bestückten Zustand auf dem Substrat. Hierdurch kommt eine Fügekraft P zustande, die beispielsweise über ein Fügewerkzeug übertragen wird.

Eine andere Ausgestaltung der Erfindung sieht vor, dass die Kontaktierungsstruktur auf den Kontaktflächen mit einem Zusatzwerkstoff versehen wird, bevor die Haube auf das Substrat aufgesetzt ist. Der Zusatzwerkstoff soll eine zuverlässige Ausbildung der Fügeverbindungen gewährleisten. Dieser kann beispielsweise aus einem Diffusionslot bestehen, wenn ein Diffusionslöten durchgeführt werden soll. Auch ist es möglich, einen Sinterwerkstoff zu verwenden, wenn eine Sinterverbindung hergestellt werden soll. Andere Möglichkeiten bestehen darin, einen Lotwerkstoff, insbesondere ein Hochtemperaturlot zu verwenden. Die Verwendung von Sinterwerkstoffen, Diffusionsloten oder Hochtemperaturloten ist dann besonders vorteilhaft, wenn die Baugruppe mit leistungselektronischen Bauelementen ausgestattet werden soll. Diese erwärmen sich während des Betriebs vergleichsweise stark, weswegen die thermischen Belastungen auch von den ausgebildeten elektrischen Kontaktierungen ertragen werden müssen. Die Kontaktierungsstruktur kann mit dem Zusatzwerkstoff versehen werden, dies hat weiterhin den Vorteil, dass das Bauelement selbst nicht mit einem Zusatzwerkstoff versehen werden muss. Die notwendigen Zusatzwerkstoffe können auf das Substrat und auf die Kontaktierungsstruktur aufgebracht werden. Hierbei genügt es vorteilhaft, nur zwei Bauteile mit dem Zusatzwerkstoff zu versehen, nämlich das Substrat und die Haube. Dies ist in der Handhabung einfacher, als wenn stattdessen mehrere Bauelemente mit dem Zusatzwerkstoff versehen werden müssten.

Die Aufgabe wird weiterhin durch die eingangs angegebene Haube gelöst, bei der auf der Innenseite der Haube eine Kontaktierungsstruktur vorgesehen ist, welche von der Stützfläche in die Kavität führt. Eine solche Haube ist, wie eingangs bereits ausführlich erläutert, zur Montage auf einem Substrat gemäß dem angeführten Verfahren geeignet. Erfindungsgemäß ist dabei vorgesehen, dass eine Überbrückung von Kontaktflächen der Baugruppe auf unterschiedlichen Fügeleveln ermöglicht wird, indem sich die in die Innenseite der Haube integrierte Kontaktierungsstruktur von der Stützfläche, die auf dem Niveau des Substrats (erster Fügelevel) liegt, zur Oberseite von Bauelementen, deren Kontaktflächen höher (zweiter Fügelevel) liegen, erstreckt. Damit vereinfacht der Einsatz der erfindungsgemäßen Haube vorteilhaft das Montageverfahren von elektrischen Bauelementen auf Substraten.

Besonders vorteilhaft ist es, wenn in der Haube auf die Kontaktflächen der Kontaktierungsstruktur ein Zusatzwerkstoff aufgebracht ist. Hierbei kann es sich, wie bereits erläutert, um ein Hochtemperaturlot, ein Diffusionslot oder ein Sintermaterial handeln. Diese Zusatzwerkstoffe stehen dann nach Montage der Haube auf der Baugruppe zur Ausbildung der Fügeverbindungen zur Verfügung. Ein Fügen kann in der oben bereits erläuterten Weise erfolgen.

Vorteilhaft ist es auch, wenn die Stützfläche durch einen Rand der Haube gebildet ist. Die Haube wird dann mit ihrem Rand auf das Substrat aufgesetzt. Sofern der Rand umlaufend ist, entsteht beim Aufsetzen der Haube auf das Substrat eine geschlossene Kavität, die vorteilhaft einen Schutz der Baugruppe gegen Verschmutzung und andere Umwelteinflüsse gewährleistet. Auf dem Rand der Haube können im Übrigen auch die Kontaktflächen bzw. die mit dem Zusatzwerkstoff versehenen Kontaktflächen vorgesehen werden, da hierdurch eine Kontaktierung der Kontaktierungsstruktur mit dem Substrat erfolgen kann.

Außerdem ist es besonders vorteilhaft, wenn die Außenseite der Haube eben ist. Dies bringt die bereits erläuterten Vorteile einer vereinfachten Montage mit sich, da das Fügewerkzeug eine ebene und damit einfache Geometrie aufweisen kann und auch für unterschiedliche Haubengeometrien (mit ebener Außenseite) Verwendung finden kann. Vorteilhaft ist es selbstverständlich, wenn die Außenseite der Haube parallel zur Stützfläche ausgebildet ist, da das Substrat, sofern dieses in waagerechter Positionierung montiert wird, auch durch waagerechtes Aufbringen der Fügewerkzeuge montiert werden kann.

Als Materialien für das elektrische Bauelement kommen Silizium, Siliziumcarbid, Galliumarsenid oder Galliumnitrid in Betracht. Diese Materialien werden vorzugsweise für leistungselektronische Bauelemente verwendet. Das Substrat kann zum Beispiel aus einer Keramik gefertigt sein. Diese kann mit Kupfer, Silber oder Gold beschichtet sein, wobei die Beschichtung zur Ausbildung von elektrischen Kontaktflächen und Leiterbahnen strukturiert sein kann. Als Zusatzwerkstoffe können je nach Fügeverfahren Hochtemperaturlote wie Antimonhaltige Legierungen oder konventionelle hoch-bleihaltige Lote, Diffusionslote der Materialsystems Sn-Cu, Sn-Cu-Ni, Sn-Cu-Ag, und vorzugweise silberhaltige Sinterpasten oder Sinterfolien zum Einsatz kommen. Im Folgenden werden exemplarisch folgende Beispiele für Zusatzwerkstoffe genannt.

Sinterverbindungen:
Silber-Sinterpaste (z.B. Heraeus mAgic Paste, Microbond ASP Serie) mit einem Temperaturbereich von 200 - 280°C

### Diffusionslötverbindungen:

Materialsystem SnCu, SnAg, SnNi und weitere Materialsysteme, die hochschmelzende intermetallische Phasen bilden können. Dabei können verschiedene Formulierungen verwendet werden, wie zum Beispiel
- Einpastensysteme mit in der Grundmatrix aus niedrigschmelzenden Legierungen (wie SnCu) dispergierten hochschmelzenden Partikeln (z.B. Cu),
- Zweipastensysteme mit sequentiellen Auftragsmethoden (hochschmelzendes Cu gefolgt von SnCu-Legierung) oder
- Methoden, den niedrigschmelzenden Zusatzwerkstoff (z.B. SnCu-Legierung) zwischen die hochschmelzenden Grenzflächen (z.B. Cu) zu applizieren, wobei unter Prozessbedingungen durch diffusive Konzentrationsänderungen die hochschmelzende Fügezone generiert wird.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
Figur 1 ein Ausführungsbeispiel der erfindungsgemäßen Haube im schematischen Querschnitt, wobei es sich hierbei auch um den ersten Schritt eines Ausführungsbeispiels des erfindungsgemäßen Verfahren handelt, und
Figur 2 und 3 weitere Verfahrensschritte dieses Ausführungsbeispiels des erfindungsgemäßen Verfahrens als Seitenansicht, teilweise geschnitten.

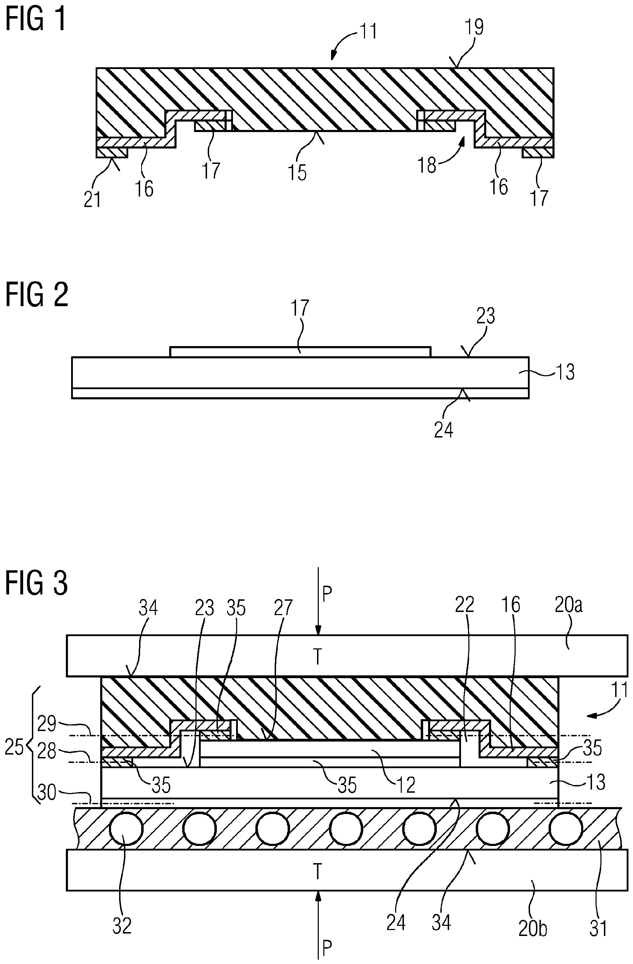

In Figur 1 ist eine Haube 11 dargestellt, die gemäß Figur 3 auf ein mit einem elektrischen Bauelement 12 ausgestattetem Substrat 13 aufgesetzt werden kann. Die Haube 11 besteht aus einem Kunststoffmaterial, mit dem das MID-Bauteil hergestellt wurde. In der Haube ist eine Innenseite 18 ausgeführt, in der Kontaktierungsstrukturen 16 mittels der MID-Technologie eingegossen oder anderweitig erzeugt wurden. Die Kontaktierungsstruktur 16 ist somit in das Material der Haube integriert, wobei die gesamte Oberseite der Kontaktierungsstruktur 16 an der Innenseite 18 der Haube 11 frei liegt. An den Enden der Kontaktierungsstruktur, die Kontaktflächen zur Kontaktierung zur Verfügung stellen, ist ein Zusatzwerkstoff 17 in Form eines Diffusionslotes vorgesehen. Die Haube weist neben der Innenseite 18 auch eine Außenseite 19 auf, wobei die Außenseite 19 eben ausgeführt ist, damit ein Fügewerkzeug 20a mit einer ebenen Druckfläche auf die Außenseite 19 der Haube aufgesetzt werden kann (vgl. Figur 3). Dabei kommt eine Fügefläche 15 zum Einsatz, die, wie Figur 3 zeigt, auf eine Oberseite 27 des zu montierenden Bauelementes 12 aufsetzt.

Auf der Innenseite 18 der Haube ist außerdem eine Stützfläche 21 gebildet, die in dem in Figur 1 dargestellten Schnitt durch den Zusatzwerkstoff 17 am äußeren Rand der Haube zur Verfügung gestellt wird. Wo kein Zusatzwerkstoff vorgesehen ist, kann diese Stützfläche 21 auch durch das Material der Haube 11 ausgebildet werden (nicht dargestellt). Die Stützfläche dient dazu, in einem weiteren Verfahrensschritt direkt auf das Substrat aufgesetzt werden zu können. Hierdurch kann das Innere der Haube gegenüber der Umgebung abgedichtet werden, so dass im Inneren eine Kavität 22 entsteht (vgl. Figur 3) .

In Figur 2 ist das Substrat 13 zu erkennen, welches eine Montageseite 23 und eine Rückseite 24 aufweist. Hierbei handelt es sich um ein nicht näher dargestelltes DCB-Keramiksubstrat, wobei die Kupferschichten nicht näher dargestellt sind. Auf der Montageseite 23 und auf der Rückseite 24 sind weitere Bereiche mit dem Zusatzwerkstoff 17 versehen, wo später verschiedene Fügepartner montiert werden sollen (vgl. Figur 3). Die nicht dargestellte Kupferschicht auf der Montageseite 23 ist in geeigneter Weise strukturiert, damit das zu montierende Bauelement 12 in geeigneter Weise kontaktiert werden kann.

In Figur 3 ist dargestellt, wie die zu montierende elektrische Baugruppe ausgebildet ist. Es ist zu erkennen, dass auf der Montageseite 23 des Substrats 13 im Bereich des Zusatzwerkstoffs (vgl. Figur 2) das Bauelement 12 mit seiner Unterseite auf die Montageseite 23 des Substrats 13 aufgesetzt wurde. Dieses Bauelement 12 weist auf seiner Oberseite 27 nicht näher dargestellte elektrische Kontakte auf. Auf die so gebildete Baugruppe, bestehend aus dem Substrat 13 und dem Bauelement 12, wird die Haube 11 gemäß Figur 1 aufgesetzt, wobei die Kontaktierungsstrukturen 16 mit ihren Enden und dem Zusatzwerkstoff (vgl. Figur 1) auf der Oberseite 27 des Bauelements 12 und der Montageseite 23 des Substrats 13 zu liegen kommen. Hierbei ist zu berücksichtigen, dass die Enden der Kontaktierungsstruktur 16 jeweils auf unterschiedlichen Niveaus liegen, die in Figur 3 als erster Fügelevel 28, vorgegeben durch die Montageseite 23 des Substrats 13, und als zweiter Fügelevel 29, vorgegeben durch Oberseite 27 des Bauelements 12, gekennzeichnet sind. Ein dritter Fügelevel 30 wird durch die Unterseite 24 des Substrats 13 zur Verfügung gestellt. Dieser dient zur Befestigung einer Grundplatte 31, die als Kühlkörper ausgeführt ist und als Bauteil über den Zusatzwerkstoff (vgl. Figur 2) mit der Unterseite 24 des Substrats 13 thermisch leitend verbunden ist. In der Grundplatte 23 können zum Zwecke der Kühlung beispielsweise Kühlkanäle 32 vorgesehen sein. Die Baugruppe gemäß Figur 3 ist nun vormontiert. Das heißt, dass die einzelnen Komponenten (Grundplatte 31, Substrat 13, Bauelement 12, Kontaktierungsstruktur 16) in der zu erzeugenden Konfiguration zueinander platziert wurden. Der Zusatzwerkstoff 17 sorgt dafür, dass diese Konfiguration für Handhabungszwecke im weiteren Verfahren der Fertigung bereits eine genügende Stabilität aufweist. Zu diesem Zwecke können außerdem nicht näher dargestellte Fügehilfen vorhanden sein. Diese können beispielsweise aus externen Werkzeugen, wie beispielsweise Klammern, bestehen. Auch ist es möglich, in die einzelnen Bauteile Fügehilfen, wie beispielsweise Clipverbindungen, zu integrieren (nicht dargestellt). Die Halterung der einzelnen Komponenten der Baugruppe mittels dieser Fügehilfen ist nur vorläufig bis zur endgültigen Montage der Baugruppe.

Die endgültige Montage ist ebenfalls in Figur 3 angedeutet. Die Baugruppe wird in ein geeignetes Werkzeug eingelegt. Dieses besteht aus Fügewerkzeugen 20a, 20b, welche von unten und von oben an die fertigzustellende Baugruppe 25 herangeführt werden. Die Fügewerkzeuge verfügen über Auflageflächen 34, mit denen eine Druckkraft P auf die zu fügenden Bauteile ausgeübt werden kann. Diese Auflageflächen 34 sind vorteilhaft eben ausgeführt, was dadurch gelingt, dass sowohl die Grundplatte 31 als auch die Haube 11 in geeigneter Weise ebene Auflageflächen für die Fügewerkzeuge 20a, 20b zur Verfügung stellen. Daher kann eine nicht näher dargestellte Heizung, mit denen die Fügewerkzeuge auf die Temperatur T gebracht werden, die Wärme über die gesamte Auflagefläche 34 auf die Baugruppe 25 übertragen. Die Wärme in den Fügewerkzeugen kann beispielsweise über eine nicht dargestellte elektrische Widerstandsheizung erfolgen. Zusammen mit der erforderlichen Druckkraft P wird der Zusatzwerkstoff (vgl. Figur 1) in Fügeverbindungen 35 gemäß Figur 3 umgewandelt, so dass die Baugruppe auf diese Weise bleibend montiert wird.

## Patentansprüche

1. Verfahren zum Montieren eines elektrischen Bauelementes (12) auf einem Substrat (13), wobei bei dem Verfahren
• das Bauelement eine dem Substrat zugewandte Unterseite und eine dieser genüberliegenden Oberseite (27) aufweist,
• die Unterseite des Bauelementes (12) mit der durch das Substrat (13) zur Verfügung stehenden Baugruppe durch Ausbilden einer Fügeverbindung (35) mechanisch verbunden wird,
• die Oberseite (27) des Bauelementes (12) und eine Montageseite (23) des Substrates (13) über eine Kontaktierungsstruktur (16) durch Ausbilden von Fügeverbindungen (35) mechanisch verbunden wird,
• die Fügeverbindungen, die beim Fügen entstehen, in mindestens zwei unterschiedlichen Fügeleveln (28, 29) liegen,
• die Kontaktierungsstruktur (16) in Form von auf der Innenseite einer Haube (11) verlaufenden Leitpfaden ausgeführt ist, wobei
• die Haube (11) bei der Montage das Bauelement (12) überspannt,
• die Haube (11) bei der Montage auf die Montageseite (23) des Substrates (13) aufgesetzt wird, wobei eine mechanische Kontaktierung der Kontaktierungsstruktur (16) mit dem Substrat (13) innerhalb eines ersten Fügelevels (28), der durch die Montageseite (23) des Substrates (13) zur Verfügung gestellt wird, erzeugt wird, wobei die Unterseite des Bauelements innerhalb des ersten Fügelevels (28) liegt,
• wobei auf der Innenseite der Haube (11) bei der Montage innerhalb eines zweiten Fügelevels (29) auf Höhe der Oberseite (27) des Bauelementes eine elektrische Kontaktierung der Kontaktierungsstruktur (16) mit dem Bauelement (12) erzeugt wird, wobei die Oberseite des Bauelements innerhalb des zweiten Fügelevels (29) liegt, **dadurch gekennzeichnet, dass**
• das Substrat (13), das Bauelement (12) und die Haube (11) zusammengesetzt werden, bevor
• alle Fügeverbindungen (35) am Bauelement (12) im ersten Fügelevel (28) und am Bauelement (12) im zweiten Fügelevel (29) in ein und demselben Arbeitsgang durch eine Temperaturerhöhung oder eine Temperatur- und Druckerhöhung fertiggestellt werden,
wobei die Haube (11) als ein durch Technologie von Typ"Low-Temperature-Co-fired-Ceramics" hergestelltes Bauteil, LTCC-Bauteil, oder als ein durch Technologie von Typ "Molded Interconnect Device" hergestelltes Bauteil, MID-Bauteil, ausgeführt ist.

2. Verfahren nach einem der voranstehenden Ansprüche,
**dadurch gekennzeichnet,**
**dass**
• das Substrat (13) mit seiner der Montageseite (23) abgekehrten Rückseite (24), die einen dritten Fügelevel (30) zur Verfügung stellt, mit einem Bauteil (31) zusammengesetzt wird, bevor
• eine Verbindung zwischen dem Bauteil (31) und dem Substrat (13) in demjenigen Arbeitsgang fertiggestellt wird, in dem auch die Fügeverbindungen (35) am Bauelement (12) in dem ersten Fügelevel (28) und in dem zweiten Fügelevel (29) fertiggestellt werden.

3. Verfahren nach einem der voranstehenden Ansprüche,
**dadurch gekennzeichnet,**
**dass** die Haube (11) außen eine ebene Fläche aufweist, die parallel zum Substrat verläuft.

4. Verfahren nach einem der voranstehenden Ansprüche,
**dadurch gekennzeichnet,**
**dass** auf der Innenseite mindestens eine Fügefläche (15) vorgesehen ist, die bei der Montage auf dem Substrat (13) mit dem Bauelement (12) in Eingriff gelangen.

5. Verfahren nach Anspruch 4,
**dadurch gekennzeichnet,**
**dass** die Fügefläche (15) mit der Oberseite (27) des elektrischen Bauelementes (12) in Eingriff gebracht wird, wobei die so entstehende Kontaktfläche außerhalb der elektrischen Kontaktierung liegt.

6. Verfahren nach einem der Ansprüche 1 bis 3,
**dadurch gekennzeichnet,**
**dass** das Fertigstellen der Fügeverbindungen durch Diffusionslöten oder Sintern erfolgt.

7. Verfahren nach einem der voranstehenden Ansprüche,
**dadurch gekennzeichnet,**
**dass** die Kontaktierungsstruktur (16) auf Kontaktflächen mit einem Zusatzwerkstoff (17) versehen wird, bevor die Haube (11) auf das Substrat (13) aufgesetzt wird.

## Claims

1. Method for mounting an electrical component (12) on a substrate (13), wherein in the method
• the component has a bottom side facing towards the substrate and has a top side (27) situated opposite said bottom side,
• the bottom side of the component (12) is mechanically connected to the assembly provided by the substrate (13) by formation of a joining connection (35),
• the top side (27) of the component (12) and a mounting side (23) of the substrate (13) are mechanically connected by way of a contacting structure (16) by formation of joining connections (35),
• the joining connections that are formed during the joining process are situated in at least two different joining levels (28, 29),
• the contacting structure (16) is constructed in the form of conductor paths running on the inner side of a cover (11), wherein
• the cover (11), during the mounting process, traverses the component (12),
• the cover (11), during the mounting process, is placed onto the mounting side (23) of the substrate (13), wherein mechanical contacting is generated between the contacting structure (16) and the substrate (13) within a first joining level (28) which is provided by the mounting side (23) of the substrate (13), wherein the bottom side of the component is situated within the first joining level (28),
• wherein, during the mounting process, on the inner side of the cover (11), electrical contacting is generated between the contacting structure (16) and the component (12) within a second joining level (29) at the level of the top side (27) of the component, wherein the top side of the component is situated within the second joining level (29), **characterized in that**
• the substrate (13), the component (12) and the cover (11) are assembled before
• all the joining connections (35) on the component (12) in the first joining level (28) and on the component (12) in the second joining level (29) are completed in one and the same working step by way of a temperature increase or a temperature and pressure increase,
wherein the cover (11) is designed as a component produced by technology of the "Low Temperature Co-Fired Ceramics" type, LTCC component, or as a component produced by technology of the "Moulded Interconnect Device" type, MID component.

2. Method according to one of the preceding claims,
**characterized**
**in that**
• the substrate (13), by way of its rear side (24) which is averted from the mounting side (23) and which provides a third joining level (30), is assembled with a component part (31) before
• a connection between the component part (31) and the substrate (13) is completed in the working step in which the joining connections (35) on the component (12) in the first joining level (28) and in the second joining level (29) are also completed.

3. Method according to one of the preceding claims,
**characterized**
**in that** the cover (11) has, on the outside, a planar surface which runs parallel to the substrate.

4. Method according to one of the preceding claims,
**characterized**
**in that**, on the inner side, at least one joining surface (15) is provided which, during the mounting on the substrate (13), enters into engagement with the component (12).

5. Method according to Claim 4,
**characterized**
**in that** the joining surface (15) is brought into engagement with the top side (27) of the electrical component (12), wherein the contact surface thus generated is situated outside the electrical contacting.

6. Method according to one of Claims 1 to 3,
**characterized**
**in that** the completion of the joining connections is performed by diffusion soldering or sintering.

7. Method according to one of the preceding claims,
**characterized**
**in that** the contacting structure (16) is provided, on contact surfaces, with an additional material (17) before the cover (11) is placed onto the substrate (13).

## Revendications

1. Procédé de montage d'un composant (12) électrique sur un substrat (13), dans lequel, dans le procédé
• le composant a un côté inférieur tourné vers le substrat et un côté (27) supérieur opposé à celui-ci,
• on relie, mécaniquement en constituant une liaison (35) par jointure, le côté inférieur du composant (12) au module mis à disposition par le substrat (13),
• on relie, mécaniquement en constituant des liaisons (35) par jointure, le côté (27) supérieur du composant (12) et un côté (23) de montage du substrat (13) par une structure (16) de mise en contact,
• les liaisons par jointure, qui se créent à la jointure, se trouvent dans au moins deux niveaux (28, 29) de jointure différents,
• la structure (16) de mise en contact est réalisée sous la forme de chemins conducteurs s'étendant sur la face intérieure d'une coiffe (11), dans lequel
• la coiffe (11) recouvre le composant (12) lors du montage,
• on met la coiffe (11), lors du montage, sur le côté (23) de montage du substrat (13), dans lequel on produit une mise en contact mécanique de la structure (16) de mise en contact avec le substrat (13) au sein d'un premier niveau (28) de jointure, que l'on met à disposition par le côté (23) de montage du substrat (13), dans lequel le côté inférieur du composant est dans le premier niveau (28) de jointure,
• dans lequel, sur la face intérieure de la coiffe (11), on produit, lors du montage dans un deuxième niveau (29) de jointure à hauteur du côté (27) supérieur du composant, une mise en contact électrique de la structure (16) de mise en contact avec le composant (12), dans lequel le côté supérieur du composant se trouve dans le deuxième niveau (29) de jointure, **caractérisé en ce que**
• on rassemble le substrat (13), le composant (12) et la coiffe (11), avant
• de finir toutes les liaisons (35) par jointure sur le composant (12) dans le premier niveau (28) de jointure et sur le composant (12) dans le deuxième niveau (29) de jointure dans une seule et même passe opératoire par une élévation de température et/ou une élévation de température et de pression,
dans lequel la coiffe (11) est réalisée sous la forme d'un composant préparé par une technologie de type « Low Température Co fired Ceramics », composant LTCC, ou sous la forme d'un composant produit par une technologie de type « Molded Interconnect Device », composant MID.

2. Procédé suivant l'une des revendications précédentes,
**caractérisé**
**en ce que**
• on rassemble avec un composant (31) le substrat (13) par son côté (24) arrière, qui est opposé à son côté (23) de montage et qui met à disposition un troisième niveau (30) de jointure, avant
• de finir une liaison entre le composant (31) et le substrat (13) dans la même passe opératoire, dans laquelle on finit également les liaisons (35) par jointure sur le composant (12) dans le premier niveau (28) de jointure et dans le deuxième niveau (29) de jointure.

3. Procédé suivant l'une des revendications précédentes,
**caractérisé**
**en ce que** la coiffe (11) a, à l'extérieur, une surface plane, qui s'étend parallèlement au substrat.

4. Procédé suivant l'une des revendications précédentes,
**caractérisé**
**en ce qu'**il est prévu, sur la face intérieure, au moins une surface (15) de jointure, qui, lors du montage sur le substrat (13), vient en prise avec le composant (12).

5. Procédé suivant la revendication 4,
**caractérisé**
**en ce que** l'on met en prise la surface (15) de jointure avec le côté (27) supérieur du composant (12) électrique, dans lequel la surface de contact ainsi créée est à l'extérieur de la mise en contact électrique.

6. Procédé suivant l'une des revendications 1 à 3,
**caractérisé**
**en ce que** l'on effectue la finition des liaisons par jointure par brasage par diffusion ou par frittage.

7. Procédé suivant l'une des revendications précédentes,
**caractérisé**
**en ce que** l'on munit la structure (16) de mise en contact, sur les surfaces de contact, d'un matériau (17) d'apport, avant de mettre la coiffe (11) sur le substrat (13).
